# EUROPEAN PATENT APPLICATION

(11) **EP 4 525 044 A1**
(43) Date of publication of application: **19.03.2025**
(21) Application number: 23814982.7
(22) Date of filing: 18.05.2023
(51) Int. Cl.: H01L 27/10, G11C 11/22

(54) **FERROELECTRIC MEMORY AND PREPARATION METHOD THEREFOR, AND ELECTRONIC DEVICE**

(30) Priority: 02.06.2022 CN 202210621994
(71) Applicant: Huawei Technologies Co., Ltd., Shenzhen, Guangdong 518129 (CN)
(72) Inventor: ZHANG, Yu, Shenzhen, Guangdong 518129 (CN); ZHANG, Heng, Shenzhen, Guangdong 518129 (CN); YU, Fangzhou, Shenzhen, Guangdong 518129 (CN); LI, Yue, Shenzhen, Guangdong 518129 (CN); SUN, Yiming, Shenzhen, Guangdong 518129 (CN); LV, Hangbing, Shenzhen, Guangdong 518129 (CN); XU, Jeffrey Junhao, Shenzhen, Guangdong 518129 (CN)
(74) Representative: Isarpatent
(86) International application number: PCT/CN2023/095077
(87) International publication number: WO 2023/231798

(57) **Abstract**

This application provides a ferroelectric random access memory, a preparation method thereof, and an electronic device, and relates to the field of semiconductor technologies, to prolong a service life of the ferroelectric random access memory. The ferroelectric random access memory includes a ferroelectric capacitor. The ferroelectric capacitor includes a first electrode and a second electrode that are disposed opposite to each other, and a plurality of ferroelectric layers disposed between the first electrode and the second electrode. **In** addition, the ferroelectric capacitor further includes a plurality of barrier layers, the plurality of barrier layers are disposed between the first electrode and the second electrode, and the barrier layers and the ferroelectric layers are alternately stacked. At least one barrier layer is located between a ferroelectric layer and the first electrode, and/or at least one barrier layer is located between a ferroelectric layer and the second electrode. The ferroelectric random access memory is a random access memory, and may be used as an internal memory in an electronic device, to implement data read and write operations.

## Description

This application claims priority to Chinese Patent Application No. 202210621994.3, filed with the China National Intellectual Property Administration on June 2, 2022 and entitled "FERROELECTRIC RANDOM ACCESS MEMORY, PREPARATION METHOD THEREOF, AND ELECTRONIC DEVICE", which is incorporated herein by reference in its entirety.

### TECHNICAL FIELD

This application relates to the field of semiconductor technologies, and in particular, to a ferroelectric random access memory and a preparation method thereof, and an electronic device.

### BACKGROUND

Currently, a ferroelectric random access memory (ferroelectric random access memory, FeRAM for short) is widely applied for features such as non-volatile storage data and a high access rate of the ferroelectric random access memory.

Generally, the ferroelectric random access memory has a plurality of storage units. Each storage unit includes a ferroelectric capacitor, and the ferroelectric capacitor includes two electrodes disposed opposite to each other and a ferroelectric material disposed between the two electrodes. The ferroelectric capacitor has a metal-insulator-metal (metal-insulator-metal, MIM for short) structure. The ferroelectric material has ferroelectric effect. The ferroelectric effect means that the ferroelectric material has a spontaneous polarization feature, and a polarization direction of the ferroelectric material may be changed by applying an electric field to the ferroelectric material by using the two electrodes. The ferroelectric random access memory stores data by using the ferroelectric effect of the ferroelectric material.

However, when the ferroelectric capacitor is in a high operating electric field or in an environment with a high ambient temperature for long time, metal ions in the electrode of the ferroelectric capacitor move, and diffuse into the ferroelectric material to form a conductive path. As a result, a leakage current in the ferroelectric capacitor increases, and further a service life of the ferroelectric random access memory is reduced.

### SUMMARY

Embodiments of this application provide a ferroelectric random access memory, a preparation method thereof, and an electronic device, to reduce a leakage current in a ferroelectric capacitor and prolong a service life of the ferroelectric random access memory.

To achieve the foregoing objectives, the following technical solutions are used in embodiments of this application.

According to a first aspect, a ferroelectric random access memory is provided. The ferroelectric random access memory is a random access memory, and may be used as an internal memory. The ferroelectric random access memory has features such as non-volatile storage of data and a high access rate. The ferroelectric random access memory includes a ferroelectric capacitor. The ferroelectric capacitor includes a first electrode and a second electrode that are disposed opposite to each other, and a plurality of ferroelectric layers disposed between the first electrode and the second electrode. **In** addition, the ferroelectric capacitor further includes a plurality of barrier layers, the plurality of barrier layers are disposed between the first electrode and the second electrode, and the barrier layers and the ferroelectric layers are alternately stacked. At least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

In the foregoing embodiment of this application, in the ferroelectric capacitor of the ferroelectric random access memory, the barrier layer is disposed between the first electrode and the ferroelectric layer, or the barrier layer is disposed between the second electrode and the ferroelectric layer, or the barrier layers are disposed between the first electrode and the ferroelectric layer and between the second electrode and the ferroelectric layer. **In** other words, at least one of the first electrode and the second electrode is not in direct contact with the ferroelectric layer.

The barrier layer is disposed between the electrodes (the first electrode and/or the second electrode) and the ferroelectric layer, so that the barrier layer can suppress metal ions in the electrodes to diffuse into the ferroelectric layer, and can suppress oxygen ions in the ferroelectric layer to diffuse into the electrodes, to reduce an oxygen vacancy formed due to movement of the oxygen ions in the ferroelectric layer, and weaken oxidation effect between the electrodes and the oxygen ions. This avoids forming a conductive path by the metal ions and the oxygen vacancy between the first electrode and the second electrode, reduces a leakage current in the ferroelectric capacitor, avoids breakdown of the ferroelectric capacitor, and prolongs a service life of the ferroelectric random access memory.

In addition, the ferroelectric layers and the barrier layers are alternately stacked. This is equivalent to that a ferroelectric film is disposed between the first electrode and the second electrode. The plurality of barrier layers are inserted into different positions of the ferroelectric film, and the ferroelectric film is divided into the plurality of ferroelectric layers by the plurality of barrier layers. The plurality of barrier layers can suppress diffusion of the metal ions and the oxygen ions between adjacent ferroelectric layers, weaken oxidation effect of the electrodes and the oxygen ions, and reduce a quantity of oxygen vacancies in the ferroelectric layer, prevent forming the conductive path by the metal ions and the oxygen vacancy, and therefore prolong the service life of the ferroelectric random access memory.

In some embodiments, a material of the barrier layer includes graphene, and the graphene has a single-layer two-dimensional cellular lattice structure formed by tightly stacking carbon atoms connected by sp² hybridization. The structure enables the barrier layer to have good barrier performance, and improves a capability of the barrier layer to suppress diffusion of the metal ions and the oxygen ions.

In addition, the graphene has a feature of low resistivity, and can weaken a voltage division capability of the barrier layer. This helps reduce consumption of an operating voltage on the barrier layer, increases an effective voltage applied to the ferroelectric layer (used for ferroelectric domain flipping), improves a degree of distinguishing between a positive polarization state and a negative polarization state of the ferroelectric layer, facilitates an external circuit to identify the positive polarization state and the negative polarization state of the ferroelectric layer, and therefore improves accuracy of reading or writing data by the ferroelectric random access memory.

In some embodiments, a material of the barrier layer includes single-layer graphene. The single-layer graphene is thin and has a small resistance. This can further weaken a voltage division capability of the barrier layer, reduce consumption of the operating voltage on the barrier layer, improve the effective voltage applied to the ferroelectric layer, and therefore improve accuracy of reading or writing data by the ferroelectric random access memory.

In some embodiments, the ferroelectric capacitor includes at least three ferroelectric layers. In a direction from the first electrode to the second electrode, thicknesses of the at least three ferroelectric layers first increase and then decrease.

At a position close to the first electrode or the second electrode, a diffusion concentration of the metal ions and the oxygen vacancy is large, and at a position away from the first electrode or the second electrode, the diffusion concentration of the metal ions and the oxygen vacancy is small. Therefore, in the foregoing disposing manner, in the direction from the first electrode to the second electrode, spacings between the plurality of barrier layers first become larger, and then become smaller. The plurality of barrier layers have a small spacing at a position close to the electrode, and have a large spacing at a position away from the electrode. This can further suppress diffusion of the metal ions and the oxygen ions between the adjacent ferroelectric layers, weaken the oxidation effect of the electrode and the oxygen ions, reduce the quantity of the oxygen vacancies in the ferroelectric layer is reduced, and further avoid forming the conductive path by the metal ions and the oxygen vacancy.

In some embodiments, a thickness of the barrier layer ranges from 0.334 nm to 0.4 nm. The thickness of the barrier layer is thin. This helps reduce resistance of the barrier layer, weaken the voltage division capability of the barrier layer, reduce consumption of the operating voltage on the barrier layer, and increase the effective voltage applied to the ferroelectric layer.

In some embodiments, a material of at least one of the first electrode and the second electrode includes titanium nitride, and material costs of the titanium nitride are low. In addition, a titanium nitride film may be prepared by using an atomic layer deposition process. The process is compatible with a complementary metal oxide semiconductor process. In a process of etching the titanium nitride film, the titanium nitride does not easily cause contamination of an etching cavity.

**In** some embodiments, the first electrode and the second electrode of the ferroelectric capacitor are planar electrodes, and the first electrode and the second electrode are stacked. The ferroelectric capacitor is of a two-dimensional planar structure, and has a simple structure and is easy to prepare.

In some embodiments, the ferroelectric random access memory includes a plurality of storage units arranged in an array, and the storage unit includes the ferroelectric capacitor and a transistor. When the first electrode and the second electrode of the ferroelectric capacitor are the planar electrodes, that is, the ferroelectric capacitor is of the two-dimensional planar structure, one of the first electrode and the second electrode is electrically connected to the transistor.

According to a second aspect, a preparation method of a ferroelectric random access memory is provided. The preparation method includes: forming a first electrode; alternately forming a plurality of barrier layers and a plurality of ferroelectric layers on the first electrode; and forming a second electrode on the plurality of barrier layers and the plurality of ferroelectric layers. At least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

According to the preparation method provided in the foregoing embodiment of this application, the barrier layer is formed between the first electrode and the ferroelectric layer, or the barrier layer is formed between the second electrode and the ferroelectric layer, or the barrier layers are formed between the first electrode and the ferroelectric layer and between the second electrode and the ferroelectric layer. The barrier layer can suppress diffusion of metal ions and oxygen ions, weaken oxidation effect of the electrode and the oxygen ions, reduce a quantity of oxygen vacancies in the ferroelectric layer, prevent forming a conductive path between the metal ions and the oxygen vacancy, and therefore prolong a service life of the ferroelectric random access memory.

In some embodiments, forming the barrier layer includes: forming the barrier layer on a substrate by using a deposition process; and transferring the barrier layer to the first electrode or the ferroelectric layer. A material of the barrier layer includes single-layer graphene, and the method may be applied to preparation of the single-layer graphene.

According to a third aspect, a ferroelectric random access memory is provided. In a ferroelectric capacitor of the ferroelectric random access memory, a first electrode is a planar electrode, a second electrode is a columnar electrode, the second electrode penetrates the first electrode, and a plurality of barrier layers and a plurality of ferroelectric layers are disposed around the second electrode. In other words, the ferroelectric capacitor uses a three-dimensional vertical structure design, so that an occupied area of the ferroelectric capacitor in a plane can be reduced. This increases a quantity of ferroelectric capacitors disposed per unit area in the plane, and helps improve a storage density of the ferroelectric random access memory.

In some embodiments, the ferroelectric random access memory includes a plurality of storage units arranged in an array, and the storage unit includes the ferroelectric capacitor and a transistor. When the first electrode of the ferroelectric capacitor is a planar electrode, and the second electrode is a columnar electrode, the ferroelectric capacitor is of a three-dimensional vertical structure, and the second electrode of the ferroelectric capacitor is electrically connected to the transistor.

According to a fourth aspect, a preparation method of a ferroelectric random access memory is provided. The preparation method includes: forming a first electrode; forming a hole that penetrates the first electrode; alternately forming a plurality of barrier layers and a plurality of ferroelectric layers on a side wall of the hole; and forming a second electrode on an inner side of the plurality of barrier layers and the plurality of ferroelectric layers. At least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

According to the preparation method provided in the foregoing embodiment of this application, the barrier layer is formed between the first electrode and the ferroelectric layer, or the barrier layer is formed between the second electrode and the ferroelectric layer, or the barrier layers are formed between the first electrode and the ferroelectric layer and between the second electrode and the ferroelectric layer. The barrier layer can suppress diffusion of metal ions and oxygen ions, weaken oxidation effect of an electrode and the oxygen ions, reduce a quantity of oxygen vacancies in the ferroelectric layer, prevent forming a conductive path by the metal ions and the oxygen vacancies, and therefore prolong a service life of the ferroelectric random access memory.

In some embodiments, the forming the barrier layer includes: forming the barrier layer on the side wall of the hole or on the inner side of the ferroelectric layer by using a deposition process. A material of the barrier layer includes single-layer graphene, and the barrier layer may be directly formed on the side wall of the hole or the inner side of the ferroelectric layer by using a chemical vapor deposition process, so that a preparation process can be simplified and preparation costs can be reduced.

According to a fifth aspect, an electronic device is provided. The electronic device includes a circuit board and the ferroelectric random access memory according to any one of the foregoing embodiments. The ferroelectric random access memory is disposed on the circuit board and is electrically connected to the circuit board.

It may be understood that, for beneficial effects that can be achieved by the electronic device provided in the foregoing embodiments of this application, refer to the foregoing beneficial effects of the ferroelectric random access memory. Details are not described herein again.

### BRIEF DESCRIPTION OF DRAWINGS

To describe technical solutions in this application more clearly, the following briefly describes accompanying drawings for describing some embodiments of this application. It is apparent that the accompanying drawings in the following description are merely accompanying drawings in some embodiments of this application. For a person of ordinary skill in the art, other drawings may also be derived from these drawings. In addition, the accompanying drawings in the following description may be considered as diagrams, and are not intended to limit an actual size of a product, an actual procedure of a method, an actual time sequence of a signal, and the like in embodiments of this application.
FIG. 1 is a diagram of an architecture of an electronic device according to some embodiments;
FIG. 2 is an exploded view of an electronic device according to some embodiments;
FIG. 3 is a diagram of an architecture of a ferroelectric random access memory according to some embodiments;
FIG. 4 is a circuit diagram of a storage unit according to some embodiments;
FIG. 5 is a diagram of a structure of a ferroelectric capacitor in a related technology;
FIG. 6 is a diagram of generating a thin metal wire in a ferroelectric layer of a ferroelectric capacitor;
FIG. 7 is a diagram of generating an oxygen vacancy in a ferroelectric layer of a ferroelectric capacitor;
FIG. 8 is a curve diagram of an electric hysteresis loop of a ferroelectric layer of a ferroelectric capacitor;
FIG. 9 is a diagram of a conductive path generated by an oxygen vacancy in a ferroelectric layer of a ferroelectric capacitor;
FIG. 10 is a curve diagram of a relationship between a quantity of flipping times of a ferroelectric layer of a ferroelectric capacitor and two times of remaining polarization strength;
FIG. 11A to FIG. 11C are diagrams of structures of a plurality of ferroelectric capacitors of a ferroelectric random access memory according to some embodiments;
FIG. 12 is a diagram of suppressing diffusion of metal ions and oxygen ions by a barrier layer according to some embodiments;
FIG. 13A is a diagram of a structure of another ferroelectric capacitor of a ferroelectric random access memory according to some embodiments;
FIG. 13B is a diagram of a structure of still another ferroelectric capacitor of a ferroelectric random access memory according to some embodiments;
FIG. 14A and FIG. 14B are flowcharts of preparing a ferroelectric capacitor according to some embodiments;
FIG. 15A to FIG. 15E are diagrams of steps of preparing a ferroelectric capacitor according to some embodiments;
FIG. 16A to FIG. 16C are diagrams of steps of preparing a ferroelectric capacitor according to some embodiments;
FIG. 17 is a diagram of a three-dimensional vertical structure of a ferroelectric capacitor according to some embodiments;
FIG. 18A and FIG. 18B are flowcharts of preparing a ferroelectric capacitor according to some embodiments; and
FIG. 19A to FIG. 19D are diagrams of steps of preparing a ferroelectric capacitor according to some embodiments.

### DESCRIPTION OF EMBODIMENTS

The following clearly and completely describes technical solutions in some embodiments of this application with reference to accompanying drawings. It is clear that the described embodiments are merely some rather than all of embodiments of this application. All other embodiments obtained by a person of ordinary skill in the art based on embodiments of this application fall within the protection scope of this application.

In the descriptions of this application, it should be understood that directions or location relationships indicated by the terms such as "center", "up", "down", "front", "rear", "left", "right", "vertical", "horizontal", "top", "bottom", "inside", and "outside" are based on the directions or the location relationships shown in the accompanying drawings, and are merely intended to describe this application and simplify the descriptions, but not intended to indicate or imply that an indicated apparatus or component shall have a specific direction or be formed and operated in a specific direction, and therefore cannot be understood as a limitation on this application.

Unless otherwise required by the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or features related to the embodiments or examples are included in at least one embodiment or example of this application. The foregoing schematic representations of the terms do not necessarily refer to a same embodiment or example. Further, the particular feature, structure, material, or feature may be included in any one or more embodiments or examples in any appropriate manner.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In the descriptions of embodiments of this application, unless otherwise specified, "a plurality of" means two or more than two.

When some embodiments are described, expressions of "coupling" and "connection" and their extensions may be used. For example, when some embodiments are described, the term "connection" may be used to indicate that two or more components are in direct physical contact or electrical contact with each other. For another example, when some embodiments are described, the term "coupled" may be used to indicate that two or more parts are in direct physical contact or electrical contact. However, the term "coupling" may also indicate that two or more components do not directly contact each other, but still collaborate or interact with each other. Embodiments of this application herein are not necessarily limited to content of this specification.

"A and/or B" includes the following three combinations: only A, only B, and a combination of A and B.

The use of "configured to" in this specification implies an open and inclusive language, and does not exclude a device that is applicable to or configured to perform an additional task or step.

In addition, the use of "based on" means openness and inclusiveness, since processes, steps, calculation, or other actions "based on" one or more of conditions or values may be based in practice on additional conditions or values outside the described values.

In the content of this application, the meanings of "on", "above", and "on the top of" should be interpreted in a broadest manner, so that "on" means not only "directly on something", but also includes the meaning of "on something" with an intermediate feature or layer between associated objects, and "above" or "on the top of" not only means "above" or "on the top of" something, but also includes the meaning of being "above" or "on the top of" something (that is, directly on something) without the intermediate feature or layer between the associated objects.

In content of this application, "same layer" refers to a layer structure formed by using a same film forming process to form a film layer for forming a specific pattern and then by using a same mask and by using a same pattern forming process. Based on different particular patterns, a patterning process may include a plurality of exposure, development, or etching processes. Moreover, the particular patterns in the formed layer structure may be continuous or discontinuous, and these particular patterns may also have different heights or different thicknesses.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending feature. Therefore, the regions shown in the accompanying drawings are essentially examples, and their shapes are not intended to show actual shapes of regions of a device, and are not intended to limit a scope of the example implementations.

Technical terms in some embodiments of this application are specifically as follows.

Cell: A cell is a structure in which a large quantity of micro matter units (such as atoms, ions, and molecules) are arranged in an orderly manner according to a specific rule.

Grain: During growth of a crystalline material, the crystalline material is crystallized into a granular shape, which is referred to as a grain. A direction and a position of an internal cell of the grain are basically the same.

Grain boundary: A contact interface between grains is referred to as a grain boundary.

Ferroelectric phase crystal: A structure of a cell makes centers of a positive charge and a negative charge do not coincide, and an electric dipole moment appears. This generates electric polarization strength that is not equal to zero, so that a crystal has spontaneous polarization. A direction of the electric dipole moment may be changed due to an external electric field. A feature similar to that of a ferromagnet appears.

Ferroelectric material: A ferroelectric material may maintain spontaneous polarization by applying an electric field to arrange an internal electric dipole moment, even when the external electric field is removed. In other words, a ferroelectric is a material in which a polarization intensity (polarization) value (or an electric field) is semi-permanently retained, even after a constant voltage is applied and the voltage is restored to zero volts.

Some embodiments of this application provide an electronic device. The electronic device may be different types of user equipment or terminal device such as a mobile phone, a tablet computer, a personal digital assistant (personal digital assistant, PDA for short), a television, or an intelligent wearable product (for example, a smartwatch or a smart band), a virtual reality (virtual reality, VR for short) terminal device, an augmented reality (augmented reality, AR for short) terminal device, a small-sized charging household appliance (for example, a soy milk maker or a robotic vacuum cleaner), an uncrewed aerial vehicle, a radar, an aerospace device, and a vehicle-mounted device. The electronic device may alternatively be a network device such as a base station.

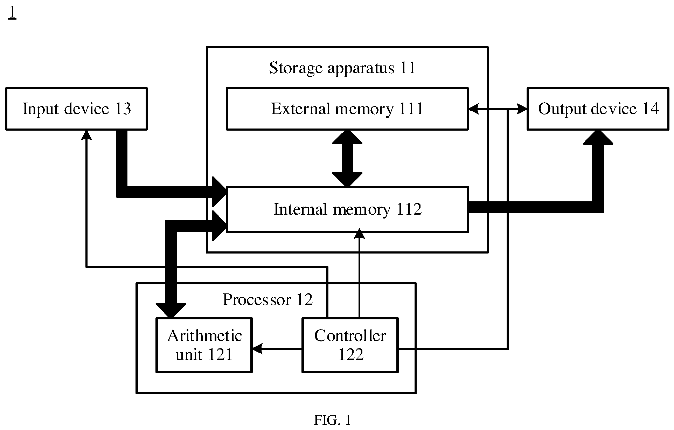

FIG. 1 is a diagram of an architecture of an electronic device according to some embodiments.

As shown in FIG. 1, the electronic device 1 includes components such as a storage apparatus 11, a processor 12, an input device 13, and an output device 14. A person skilled in the art may understand that the architecture of the electronic device 1 shown in FIG. 1 does not constitute a limitation on the electronic device 1. The electronic device 1 may include more or fewer components than those shown in FIG. 1, or may combine some of the components shown in FIG. 1. Alternatively, component arrangement may be different from that shown in FIG. 1.

The storage apparatus 11 is configured to store a software program and a module. The storage apparatus 11 mainly includes a program storage area and a data storage area. The program storage area may store and back up an operating system, an application required by at least one function (such as a sound play function or an image play function), and the like. The data storage area may store data (such as audio data, image data, and a phone book) created based on use of the electronic device 1, and the like. In addition, the storage apparatus 11 includes an external memory 111 and an internal memory 112. Data stored in the external memory 111 and the internal memory 112 may be transmitted to each other. The external memory 111 may include, for example, a hard disk, a USB flash drive, and a floppy disk. The internal memory 112 may include, for example, a random access memory (random access memory, RAM for short), a read-only memory (read-only memory, ROM for short), and the like. The random access memory may include, for example, a ferroelectric random access memory, a phase change memory, or a magnetic memory.

The processor 12 is a control center of the electronic device 1, is connected to all parts of the entire electronic device 1 through various interfaces and lines, and performs various functions and data processing of the electronic device 1 by running or executing a software program and/or a module stored in the storage apparatus 11 and invoking data stored in the storage apparatus 11. In this way, overall monitoring is performed on the electronic device 1. Optionally, the processor 12 may include one or more processing units. For example, the processor 12 may include an application processor (application processor, AP for short), a modem processor, a graphics processing unit (graphics processing unit, GPU for short), and the like. Different processing units may be independent components, or may be integrated into one or more processors. For example, the processor 12 may integrate an application processor and a modem processor. The application processor mainly processes an operating system, a user interface, an application, and the like. The modem processor mainly processes wireless communication. It may be understood that the modem processor may be not integrated into the processor 12. The application processor may be, for example, a central processing unit (central processing unit, CPU for short). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write the data.

The input device 13 is configured to receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory such as a finger or a stylus pen), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to output a signal corresponding to data that is input by the input device 13 and stored in the internal memory 112. For example, the output device 14 outputs a sound signal or a video signal. The controller 122 in the processor 12 may further control the output device 14 to output a signal or not to output a signal.

It should be noted that a thick arrow in FIG. 1 indicates data transmission, and a direction of the thick arrow indicates a data transmission direction. For example, a unidirectional arrow between the input device 13 and the internal memory 112 indicates that data received by the input device 13 is transmitted to the internal memory 112. For another example, a bidirectional arrow between the arithmetic unit 121 and the internal memory 112 indicates that the data stored in the internal memory 112 may be transmitted to the arithmetic unit 121, and data processed by the arithmetic unit 121 may be transmitted to the internal memory 112. A thin arrow in FIG. 1 indicates a component that can be controlled by the controller 122. For example, the controller 122 may control the external memory 111, the internal memory 112, the arithmetic unit 121, the input device 13, the output device 14, and the like.

For ease of further describing the structure of the electronic device 1, the following uses an example in which the electronic device 1 is a mobile phone for description.

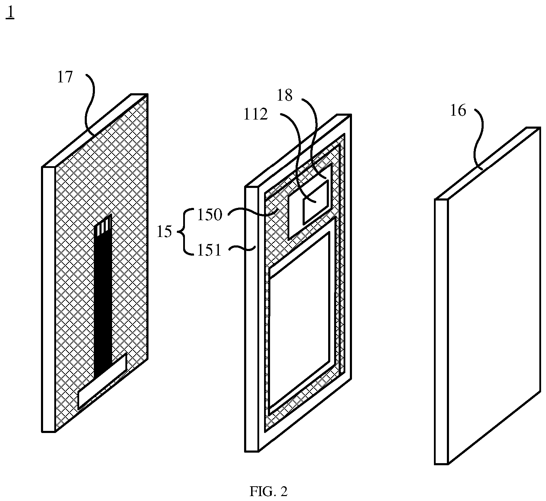

FIG. 2 is an exploded view of an electronic device according to some embodiments.

Refer to FIG. 2. The electronic device 1 may further include a middle frame 15, a rear housing 16, and a display 17. The rear housing 16 and the display 17 are respectively located on two opposite sides of the middle frame 15, and the middle frame 15 and the display 17 are disposed in the rear housing 16. The middle frame 15 includes a bearing plate 150 configured to bear the display 17, and a frame 151 that surrounds the bearing plate 150.

Still refer to FIG. 2. The electronic device 1 may further include a circuit board 18. The circuit board 18 is disposed on a side that is of the bearing plate 150 and that is close to the rear housing 16. The internal memory 112 in the electronic device 1 may be disposed on the circuit board 18. The internal memory 112 is electrically connected to the circuit board 18.

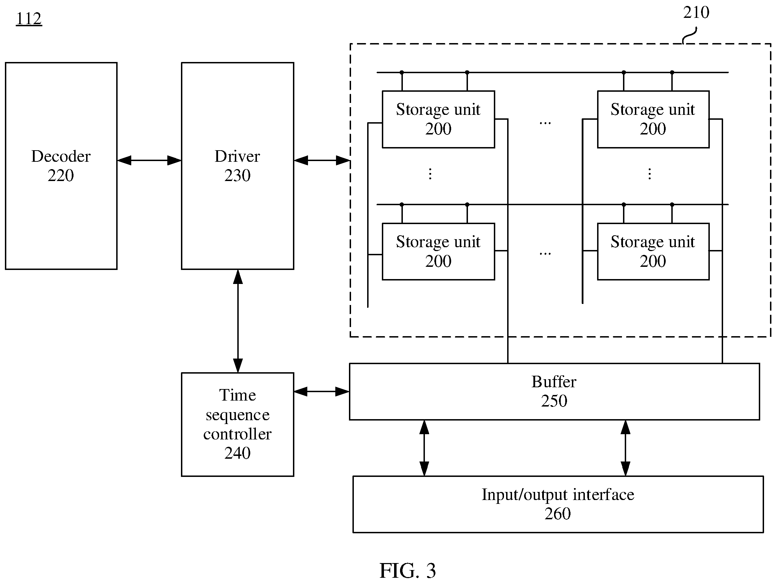

Currently, a ferroelectric random access memory becomes one of mainstream internal memories for features such as non-volatile storage data and a high access rate. In the following embodiments of this specification, an example in which the internal memory 112 is a ferroelectric random access memory is used for description. FIG. 3 is a diagram of an architecture of a ferroelectric random access memory according to some embodiments.

Refer to FIG. 3. The internal memory 112 includes a storage array 210, a decoder 220, a driver 230, a time sequence controller 240, a buffer 250, and an input/output interface 260. The storage array 210 includes a plurality of storage units 200 arranged in an array.

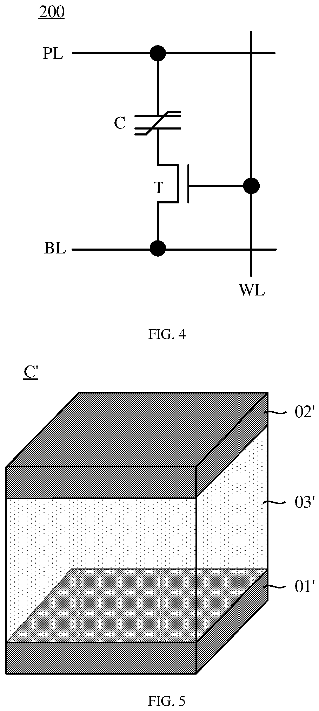

FIG. 4 is a circuit diagram of a storage unit according to some embodiments.

Refer to FIG. 4. The storage unit 200 includes a circuit architecture based on a ferroelectric capacitor. The storage unit 200 has a 1T1C (1-transistor-1-capacitor) structure. To be specific, the storage unit 200 includes a transistor T and a ferroelectric capacitor C. A source of the transistor T is electrically connected to a bit line (bit line, BL for short). A drain is electrically connected to one electrode of the ferroelectric capacitor C. A gate is electrically connected to a word line (word line, WL for short). The other electrode of the ferroelectric capacitor C is electrically connected to a plate line (plate line, PL for short). A circuit architecture of the storage unit 200 in embodiments of this application is not limited thereto.

Based on this, the decoder 220 may perform decoding according to a received address, to determine the storage unit 200 that needs to be accessed in the storage array 210. The driver 230 is configured to generate a control signal based on a decoding result output by the decoder 220. The control signal is transmitted to the gate of the transistor T in the storage unit 200 through the word line WL, to control the transistor T to be conducted or cut off, to access a specified storage unit 200. The buffer 250 receives, through the plate line PL, a data signal output by the storage unit 200, and is configured to buffer the data signal. For example, the data signal may be buffered by using First-In First-Out (first-in first-out, FIFO for short). The time sequence controller 240 is configured to control a time sequence of the buffer 250, and control the driver 230 to drive the storage array 210. The input/output interface 260 is configured to transmit a data signal, for example, receive a data signal or send a data signal.

The foregoing storage array 210, the decoder 220, the driver 230, the time sequence controller 240, the buffer 250, and the input/output interface 260 may be integrated into one chip, or may be separately integrated into a plurality of chips.

The following describes a working principle of the ferroelectric random access memory with reference to a structure of the ferroelectric capacitor.

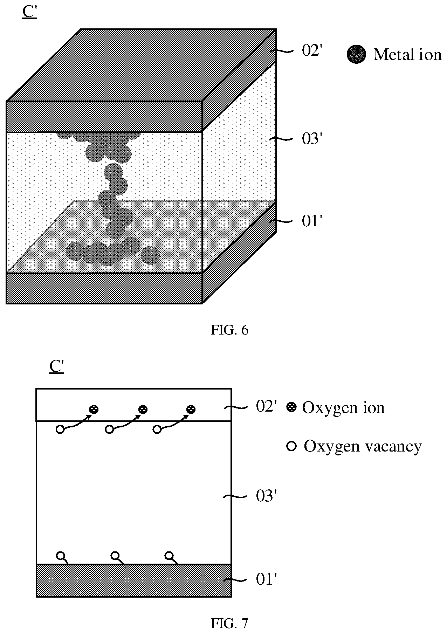

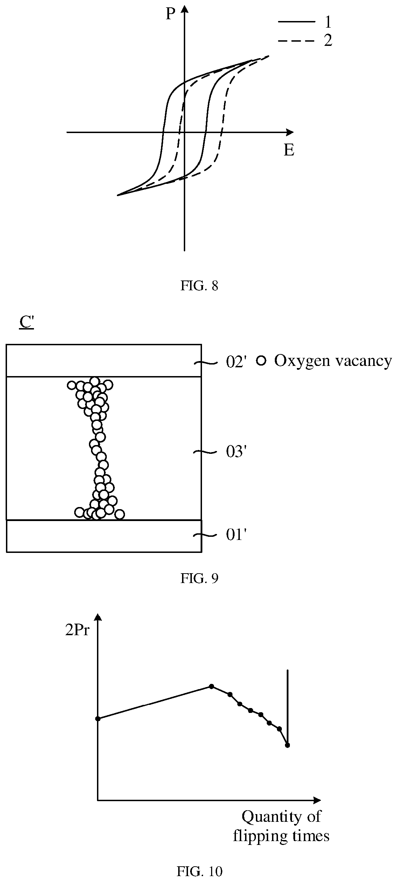

FIG. 5 is a diagram of a structure of a ferroelectric capacitor in a related technology. FIG. 6 is a diagram of generating a thin metal wire in a ferroelectric layer of a ferroelectric capacitor. FIG. 7 is a diagram of generating an oxygen vacancy in a ferroelectric layer of a ferroelectric capacitor. FIG. 8 is a curve diagram of an electric hysteresis loop of a ferroelectric layer of a ferroelectric capacitor. FIG. 9 is a diagram of a conductive path generated by an oxygen vacancy in a ferroelectric layer of a ferroelectric capacitor. FIG. 10 is a curve diagram of a relationship between a quantity of flipping times of a ferroelectric layer of a ferroelectric capacitor and two times of remaining polarization strength.

Refer to FIG. 5. A ferroelectric capacitor C' includes a first electrode 01' and a second electrode 02' that are disposed opposite to each other, and a ferroelectric layer 03' disposed between the first electrode 01' and the second electrode 02'. The ferroelectric capacitor C' has an MIM structure. The ferroelectric layer 03' includes a ferroelectric material, and the ferroelectric material has a spontaneous polarization feature. Specifically, the ferroelectric material has a ferroelectric phase crystal. When the first electrode 01' and the second electrode 02' receive a voltage signal and generate an electric field, the electric field is applied to the ferroelectric layer 03'. A central atom of the ferroelectric phase crystal in the ferroelectric material moves along the electric field and stops in a low energy state. A large quantity of central atoms move and couple in a crystal cell to form a ferroelectric domain. The ferroelectric domain forms a polarized charge under action of the electric field.

When the electric field generated by the first electrode 01' and the second electrode 02' is reversed, the central atom moves in the crystal in the direction of the electric field and stops in another low energy state, that is, the ferroelectric domain is directionally flipped under action of the reversed electric field. In addition, the ferroelectric domain has different polarized charge energy before and after the electric field is flipped. In this binary stable state (a positive polarization state and a negative polarization state), the ferroelectric capacitor C' is charged and discharged, and can be identified by an external circuit, to determine that the storage unit 200 is a storage state of "0" or "1", so that the ferroelectric random access memory reads or writes data.

However, as shown in FIG. 6, the first electrode 01' and the second electrode 02' include a metal material. Because the ferroelectric layer 03' is in direct contact with the first electrode 01' and the second electrode 02', when a voltage received by the first electrode 01' and the second electrode 02' is high, or in an environment with a high temperature, metal ions in the first electrode 01' and the second electrode 02' move and diffuse into the ferroelectric layer 03'. Diffusion concentration of the metal ions gradually decreases from being close to the electrodes (the first electrode 01' and the second electrode 02') to being inside the ferroelectric layer 03'. The metal ions accumulate to form a "thin metal wire" (also referred to as a conductive path), so that a leakage current in the ferroelectric capacitor C' increases, and the ferroelectric capacitor C' is easily broken down (breakdown). Consequently, a service life of the ferroelectric random access memory is reduced.

In addition, as shown in FIG. 7, a material of the ferroelectric layer 03' includes an oxygen-containing compound. In an environment with a high voltage or a high temperature, oxygen ions in the ferroelectric layer 03' move and diffuse to the first electrode 01' and the second electrode 02'. To be specific, the ferroelectric layer 03' is used as an oxygen ion donor, and the first electrode 01' and the second electrode 02' are used as oxygen ion receptors, so that a positive oxygen vacancy is generated inside the ferroelectric layer 03'.

In the ferroelectric layer 03', the oxygen vacancy causes a nail tie to a domain wall of a ferroelectric domain, and consequently polarization fatigue (fatigue) is generated. "Polarization fatigue" refers to a phenomenon that polarization strength decreases after the ferroelectric domain is directionally flipped for a plurality of times. Specifically, when reading or writing data, the ferroelectric random access memory performs a large quantity of editing/erasing operations, and the ferroelectric domain in the ferroelectric layer 03' is continuously flipped. After a plurality of times, remaining polarization strength of the ferroelectric domain in the ferroelectric layer 03' decreases, and a coercive field increases. The two states "0" and "1" are closer to each other. As a result, a degree of distinguishing between the positive polarization state and the negative polarization state of the ferroelectric layer 03' is reduced. Finally it becomes difficult to distinguish between the positive polarization state and the negative polarization state. This increases an error rate of reading and writing the data in the ferroelectric random access memory.

FIG. 8 is a curve diagram of an electric hysteresis loop of the ferroelectric layer 03' of the ferroelectric capacitor C'. A horizontal coordinate represents electric field strength E applied to the ferroelectric layer 03', and a vertical coordinate represents polarization strength P of the ferroelectric layer 03'. A curve "1" is an electric hysteresis loop of the ferroelectric layer 03' that does not generate an oxygen vacancy, and a curve "2" is an electric hysteresis loop of the ferroelectric layer 03' that generates an oxygen vacancy.

It can be learned that the curve "1" is centered on the origin of coordinates and is centrosymmetric, and the curve "2" is not centered on the origin of coordinates. In other words, after the ferroelectric layer 03' generates the oxygen vacancy, symmetry of the electric hysteresis loop of the ferroelectric layer 03' deteriorates, and imprint (imprint) effect is generated. The "imprint effect" means that a charge in the ferroelectric layer 03' generates a built-in electric field, which hinders flipping of a ferroelectric domain, and is represented as drift of a coercive field and increase of ferroelectric flipping time. Remaining polarization strength of the ferroelectric domain also decreases accordingly. When drift of the coercive field exceeds threshold voltages of the "0" state and the "1" state of the memory, a data read/write error occurs, and decrease of remaining polarization strength weakens strength of a data signal, and increases an error rate of reading and writing the data.

In addition, as shown in FIG. 9, in the ferroelectric layer 03', a diffusion concentration of the oxygen vacancy gradually decreases from being close to the electrodes (the first electrode 01' and the second electrode 02') to inside, and the oxygen vacancy gradually accumulates to form a conductive path, so that the leakage current in the ferroelectric capacitor C' increases, and the ferroelectric capacitor C' is easily broken down. Consequently, the service life of the ferroelectric random access memory is reduced.

FIG. 10 is a curve diagram of a relationship between a quantity of flipping times of the ferroelectric layer 03' of the ferroelectric capacitor C' and two times of remaining polarization strength. A horizontal coordinate represents a quantity of flipping times of polarization of the ferroelectric layer 03', and a vertical coordinate corresponds to two times of remaining polarization strength Pr in each flipping process of the ferroelectric layer 03'. It can be learned that, as a quantity of times of polarization flipping of the ferroelectric layer 03' increases, metal ions and/or oxygen vacancy in the ferroelectric layer 03' gradually accumulate to form a conductive path. In a process of the last polarization flipping of the ferroelectric layer 03', a sharp increase of the two times of the remaining polarization strength Pr of the ferroelectric layer 03' indicates that the ferroelectric layer 03' is broken down.

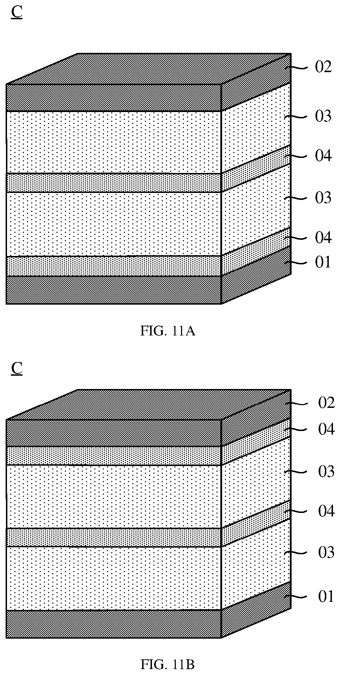

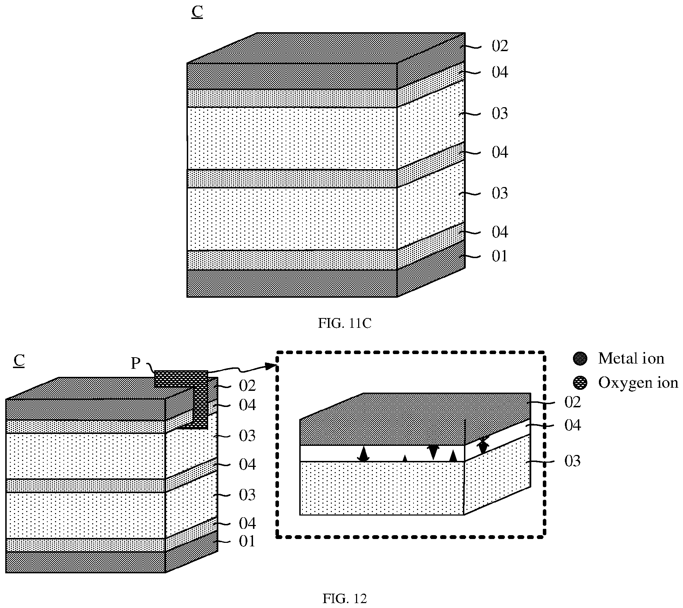

To resolve the foregoing problem, some embodiments of this application provide a ferroelectric random access memory. FIG. 11A to FIG. 11C are diagrams of structures of a plurality of ferroelectric capacitors of a ferroelectric random access memory according to some embodiments. FIG. 12 is a diagram of suppressing diffusion of metal ions and oxygen ions by a barrier layer according to some embodiments.

Refer to FIG. 11A to FIG. 11C. A ferroelectric capacitor C includes a first electrode 01 and a second electrode 02 that are disposed opposite to each other, a plurality of ferroelectric layers 03, and a plurality of barrier layers 04. The plurality of ferroelectric layers 03 and the plurality of barrier layers 04 are disposed between the first electrode 01 and the second electrode 02, and the ferroelectric layers 03 and the barrier layers 04 are alternately stacked.

For example, a material of the ferroelectric layer 03 includes zirconium-doped hafnium dioxide, also referred to as hafnium zirconium oxygen (chemical formula: HfZrOₓ). This material has a stable ferroelectric flipping property, and can improve charging and discharging performance of the ferroelectric capacitor C.

Refer to FIG. 11A. At least one barrier layer 04 is located between the first electrode 01 and the ferroelectric layer 03 that is in the plurality of ferroelectric layers 03 and that is closest to the first electrode 01. In other words, the barrier layer 04 is disposed between the first electrode 01 and the ferroelectric layer 03, so that the first electrode 01 is not in direct contact with the ferroelectric layer 03.

Refer to FIG. 11B. At least one barrier layer 04 is located between the second electrode 02 and the ferroelectric layer 03 that is in the plurality of ferroelectric layers 03 and that is closest to the second electrode 02. In other words, the barrier layer 04 is disposed between the second electrode 02 and the ferroelectric layer 03, so that the second electrode 02 is not in direct contact with the ferroelectric layer 03.

Refer to FIG. 11C. At least one barrier layer 04 is located between the first electrode 01 and the ferroelectric layer 03 that is in the plurality of ferroelectric layers 03 and that is closest to the first electrode 01, and at least one barrier layer 04 is located between the second electrode 02 and the ferroelectric layer 03 that is in the plurality of ferroelectric layers 03 and that is closest to the second electrode 02. In other words, the barrier layer 04 is disposed between the first electrode 01 and the ferroelectric layer 03 and between the second electrode 02 and the ferroelectric layer 03, so that neither the first electrode 01 nor the second electrode 02 is in direct contact with the ferroelectric layer 03.

According to the ferroelectric capacitor C provided in the foregoing embodiment of this application, the barrier layer 04 is disposed between the first electrode 01 and the ferroelectric layer 03, or the barrier layer 04 is disposed between the second electrode 02 and the ferroelectric layer 03, or the barrier layer 04 is disposed between the first electrode 01 and the ferroelectric layer 03 and between the second electrode 02 and the ferroelectric layer 03. In other words, at least one of the first electrode 01 and the second electrode 02 is not in direct contact with the ferroelectric layer 03.

Refer to FIG. 12, the barrier layer 04 is disposed between the electrodes (the first electrode 01 and/or the second electrode 02) and the ferroelectric layer 03, so that the barrier layer 04 can suppress metal ions in the electrodes to diffuse into the ferroelectric layer 03, and can suppress oxygen ions in the ferroelectric layer 03 to diffuse into the electrode, to reduce an oxygen vacancy formed due to movement of the oxygen ions in the ferroelectric layer 03, and weaken oxidation effect between the electrode and the oxygen ions. This avoids that between the first electrode 01 and the second electrode 02, the metal ions and the oxygen vacancy form a conductive path, to reduce a leakage current in the ferroelectric capacitor C, avoid breakdown of the ferroelectric capacitor C, and prolong a service life of the ferroelectric random access memory. Because the oxygen vacancy in the ferroelectric layer 03 is reduced, polarization fatigue and an imprint effect caused by the oxygen vacancy can be further improved, and accuracy of reading and writing data in the ferroelectric random access memory can be improved.

In addition, the ferroelectric capacitor C is provided with the plurality of ferroelectric layers 03 and the plurality of barrier layers 04 between the first electrode 01 and the second electrode 02, and the ferroelectric layers 03 and the barrier layers 04 are alternately stacked. This is equivalent to that a ferroelectric film is disposed between the first electrode 01 and the second electrode 02. The plurality of barrier layers 04 are inserted into different positions of the ferroelectric film, and the ferroelectric film is divided into the plurality of ferroelectric layers 03 by the plurality of barrier layers 04. The plurality of barrier layers 04 may suppress diffusion of the metal ions and the oxygen ions between adjacent ferroelectric layers 03, may weaken the oxidation effect between the electrode and the oxygen ions, reduce a quantity of oxygen vacancies in the ferroelectric layer 03, prevent forming a conductive path between the metal ions and the oxygen vacancy, to improve polarization fatigue and the imprint effect caused by the oxygen vacancy, thereby improving a service life of the ferroelectric random access memory and accuracy of reading and writing data.

In some embodiments, as shown in FIG. 11C, the ferroelectric capacitor C includes two ferroelectric layers 03. One barrier layer 04 is disposed between the first electrode 01 and the ferroelectric layer 03, and one barrier layer 04 is disposed between the second electrode 02 and the ferroelectric layer 03. One barrier layer 04 is disposed between the two ferroelectric layers 03, that is, the ferroelectric capacitor C includes three barrier layers 04 in total. This is equivalent to that a ferroelectric film is disposed between the first electrode 01 and the second electrode 02, and a barrier layer 04 is inserted into the ferroelectric film, to separate the ferroelectric film into two ferroelectric layers 03. The barrier layer 04 may suppress diffusion of metal ions and oxygen ions in the ferroelectric film, reduce a quantity of oxygen vacancies in the ferroelectric film, and may also prevent the metal ions and the oxygen vacancy to form a conductive path.

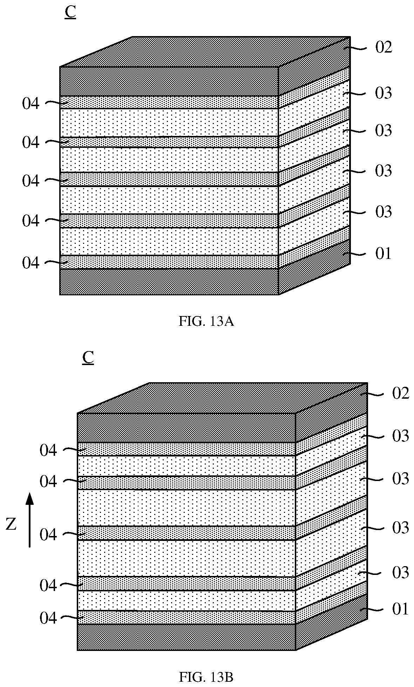

The following embodiments of this application further provide two types of ferroelectric capacitors. FIG. 13A is a diagram of a structure of another ferroelectric capacitor of a ferroelectric random access memory according to some embodiments. FIG. 13B is a diagram of a structure of still another ferroelectric capacitor of a ferroelectric random access memory according to some embodiments.

In some embodiments, as shown in FIG. 13A, a ferroelectric capacitor C includes at least three ferroelectric layers 03. One barrier layer 04 is disposed between a first electrode 01 and a ferroelectric layer 03, and one barrier layer 04 is disposed between a second electrode 02 and the ferroelectric layer 03. In the at least three ferroelectric layers 03, one barrier layer 04 is disposed between every two adjacent ferroelectric layers 03. In this embodiment of this application, a quantity of barrier layers 04 in the ferroelectric capacitor C is not limited.

This is equivalent to that a ferroelectric film is disposed between the first electrode 01 and the second electrode 02, and at least two barrier layers 04 are inserted into the ferroelectric film to divide the ferroelectric film into at least three ferroelectric layers 03. A plurality of barrier layers 04 are inserted into the ferroelectric film, so that diffusion of metal ions and oxygen ions between adjacent ferroelectric layers 03 can be further suppressed, a quantity of oxygen vacancies in the ferroelectric layer 03 can be reduced, and a conductive path formed by the metal ions and the oxygen vacancies can also be avoided.

For example, as shown in FIG. 13A, the ferroelectric capacitor C includes four ferroelectric layers 03. Correspondingly, the ferroelectric capacitor C includes five barrier layers 04 in total. One barrier layer 04 is disposed between the first electrode 01 and the ferroelectric layer 03, one barrier layer 04 is disposed between the second electrode 02 and the ferroelectric layer 03, and three barrier layers 04 are inserted into the four ferroelectric layers 03.

In some embodiments, as shown in FIG. 13B, when the ferroelectric capacitor C includes at least three ferroelectric layers 03, in a direction Z from the first electrode 01 to the second electrode 02, thicknesses of the at least three ferroelectric layers 03 first increase and then decrease.

For example, as shown in FIG. 13B, the ferroelectric capacitor C includes four ferroelectric layers 03. In the direction Z from the first electrode 01 to the second electrode 02, thicknesses of the four ferroelectric layers 03 first increase, and then decrease.

According to the foregoing description, refer to FIG. 6 and FIG. 9. In the ferroelectric layer 03' of the ferroelectric capacitor C', diffusion concentrations of metal ions and oxygen vacancies gradually decrease from approaching the electrodes (the first electrode 01' and the second electrode 02') to the inside. In other words, in a direction from the first electrode 01 to the second electrode 02, the diffusion concentrations of the metal ions and the oxygen vacancies in the ferroelectric layer 03' first decrease and then increase.

Based on this, refer to FIG. 13B. Based on a distribution rule of the diffusion concentrations of the metal ions and the oxygen vacancy in the ferroelectric layer 03', thicknesses of the plurality of ferroelectric layers 03 in the direction Z are set to first increase and then decrease. In this way, spacings between the plurality of barrier layers 04 in the direction Z first increase and then decrease.

This is equivalent to that a ferroelectric film is disposed between the first electrode 01 and the second electrode 02. A spacing between the barrier layer 04 inserted at a position that is of the ferroelectric film and that is close to the electrode is small, and a spacing between the barrier layer 04 inserted at a position that is of the ferroelectric film and that is away from the electrode is large. In other words, a spacing of the barrier layers 04 is small at a position at which diffusion concentrations of the metal ions and the oxygen vacancy are large, and a spacing of the barrier layers 04 is large at a position at which the diffusion concentrations of the metal ions and the oxygen vacancy are small. In this way, the barrier layer 04 is inserted in a targeted manner, so that diffusion of metal ions and oxygen ions between adjacent ferroelectric layers 03 can be further suppressed, oxidation effect between the electrode and the oxygen ions can be weakened, and a quantity of oxygen vacancies in the ferroelectric layer 03 can be reduced. This can also prevent the metal ions and the oxygen vacancy from forming a conductive path.

In some embodiments, a material of the barrier layer 04 includes graphene (graphene), and the graphene has a single-layer two-dimensional cellular lattice structure formed by tightly stacking carbon atoms connected by sp² hybridization. The structure enables the barrier layer 04 to have good barrier performance. A capability of the barrier layer 04 to suppress diffusion of the metal ions and the oxygen ions can be improved.

In addition, the graphene has a feature of low resistivity, and can weaken a voltage division capability of the barrier layer 04. This helps reduce consumption of an operating voltage (a voltage between the first electrode 01 and the second electrode 02) on the barrier layer 04, increases an effective voltage applied to the ferroelectric layer 03 is (used for flipping of the ferroelectric domain), and improves a degree of distinguishing between a positive polarization state and a negative polarization state of the ferroelectric layer 03. Therefore, an external circuit identifies the positive polarization state and the negative polarization state of the ferroelectric layer 03, to determine that a storage unit 200 in which the ferroelectric capacitor C is located is in a "0" or "1" storage state, thereby improving accuracy of reading or writing data by the ferroelectric random access memory.

In some embodiments, the material of the barrier layer 04 includes single-layer graphene.

It may be understood that the graphene may include the single-layer graphene and multi-layer graphene. The single-layer graphene includes a layer of carbon atoms that are periodically and tightly stacked in a benzene ring structure (that is, a hexagonal hive structure). The multi-layer graphene is also referred to as "thick layer graphene." The multi-layer graphene includes more than 10 layers of carbon atoms that are periodically and closely stacked in the benzene ring structure.

In the foregoing embodiment of this application, the barrier layer 04 is prepared by using the single-layer graphene. In comparison with the multi-layer graphene, the single-layer graphene is thinner. When other parameters of the barrier layer 04 (for example, an area of an extension surface of the barrier layer 04) are the same, resistance of the single-layer graphene is smaller, a voltage division capability of the barrier layer 04 may be further weakened, consumption of an operating voltage on the barrier layer 04 is reduced, and an effective voltage applied to the ferroelectric layer 03 is increased. This improves accuracy of reading or writing data by the ferroelectric random access memory.

In some embodiments, a thickness of the barrier layer 04 is less than a thickness of the ferroelectric layer 03.

For example, the thickness of the barrier layer 04 ranges from 0.334 nm to 0.4 nm. For example, the thickness of the barrier layer 04 is 0.334 nm, 0.34 nm, 0.36 nm, 0.38 nm, or 0.4 nm.

The thickness of the barrier layer 04 is thin. This helps reduce resistance of the barrier layer 04, weaken the voltage division capability of the barrier layer 04, reduce consumption of the operating voltage on the barrier layer 04, and increase the effective voltage applied to the ferroelectric layer 03.

A structure of the ferroelectric capacitor C provided in some embodiments of this application may be a two-dimensional planar structure. For example, refer to FIG. 11A to FIG. 11C, FIG. 13A, and FIG. 13B. The first electrode 01 and the second electrode 02 are planar electrodes, the first electrode 01 and the second electrode 02 are stacked, and the plurality of ferroelectric layers 03 and the plurality of barrier layers 04 are stacked between the first electrode 01 and the second electrode 02. The ferroelectric capacitor C has a simple structure and is easy to prepare.

For example, the storage unit 200 includes one transistor T and one ferroelectric capacitor C, and both the first electrode 01 and the second electrode 02 are planar electrodes. In this case, one of the first electrode 01 and the second electrode 02 is electrically connected to the transistor T.

In a related technology, an electrode of a ferroelectric capacitor is usually prepared by using inert metal (for example, ruthenium, platinum, or gold). Because the inert metal has strong stability, metal ions in the inert metal are not easy to move or diffuse. This can reduce a phenomenon that metal ions in the electrode diffuse into the ferroelectric layer.

However, in a process of preparing the electrode of the ferroelectric capacitor, a metal film needs to be deposited first, and then the metal film is etched by using a dry etching process, to form an electrode with a specific pattern. In a process of etching the metal film, inert metal in the metal film is sputtered into an etching cavity. The inert metal is not likely to react with clean gas, and is not likely to cause pollution of the etching cavity. In addition, material costs of the inert metal are high, resulting in relatively high component costs of the ferroelectric capacitor and the ferroelectric random access memory.

To resolve the foregoing problem, in some embodiments, a material of at least one of the first electrode 01 and the second electrode 02 includes titanium nitride. For example, a material of the first electrode 01 includes titanium nitride, or a material of the second electrode 02 includes titanium nitride, or materials of the first electrode 01 and the second electrode 02 each include titanium nitride.

It should be noted that a material of at least one of the first electrode 01 and the second electrode 02 includes titanium nitride, and material costs of the titanium nitride are low.

In addition, a titanium nitride film may be prepared by using an atomic layer deposition (atomic layer deposition, ALD for short) process. The process is compatible with a complementary metal oxide semiconductor (complementary metal-oxide-semiconductor, CMOS for short) process. In a process of etching the titanium nitride film, the titanium nitride does not easily cause contamination of an etching cavity.

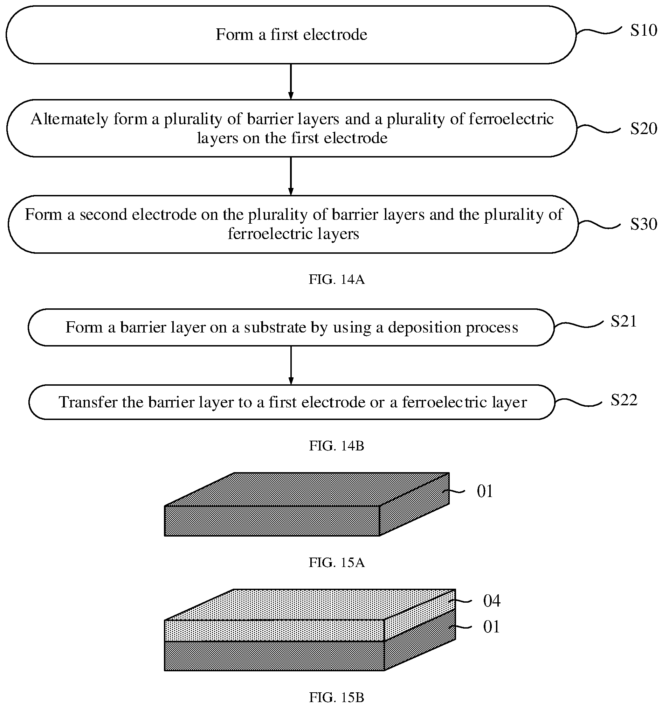

Some embodiments of this application provide a preparation method of the ferroelectric capacitor C shown in FIG. 11C. FIG. 14A and FIG. 14B are flowcharts of preparing a ferroelectric capacitor according to some embodiments. FIG. 15A to FIG. 15E are diagrams of steps of preparing a ferroelectric capacitor according to some embodiments.

Refer to FIG. 14A. The preparation method of the ferroelectric capacitor C includes the following S10 to S30.

S10: As shown in FIG. 15A, form a first electrode 01.

For example, a material of the first electrode 01 includes titanium nitride. In this case, an atomic layer deposition process may be used, titanium chloride (chemical formula: TiCl₄) is used as a precursor of Ti ion, ammonia (chemical formula: NH₃) is used as a precursor of N ion, and the titanium chloride and the ammonia are alternately fed into a film-forming cavity to form a titanium nitride film. Then, the titanium nitride film is etched to form the patterned first electrode 01.

For example, a thickness of the first electrode 01 ranges from 35 nm to 45 nm. For example, the thickness of the first electrode 01 is 35 nm, 38 nm, 40 nm, 42 nm, or 45 nm.

S20: As shown in FIG. 15B to FIG. 15D, alternately form a plurality of barrier layers 04 and a plurality of ferroelectric layers 03 on the first electrode 01.

Refer to FIG. 14B. Forming the barrier layer 04 includes the following S21 and S22.

S21: Form the barrier layer 04 on a substrate by using a deposition process.

For example, a material of the barrier layer 04 includes single-layer graphene. In this case, a copper plate is used as the substrate. The substrate is placed in a film-forming cavity. A chemical vapor deposition (chemical vapor deposition, CVD for short) process is used. A reduction gas (for example, hydrogen), a protective gas (for example, argon), and a reaction gas (for example, methane) are injected into the film-forming cavity, to form the single-layer graphene on the substrate.

S22: As shown in FIG. 15B, transfer the barrier layer 04 to the first electrode 01.

For example, the substrate may be etched off by using a wet transfer process, and the retained barrier layer 04 is transferred to the first electrode 01.

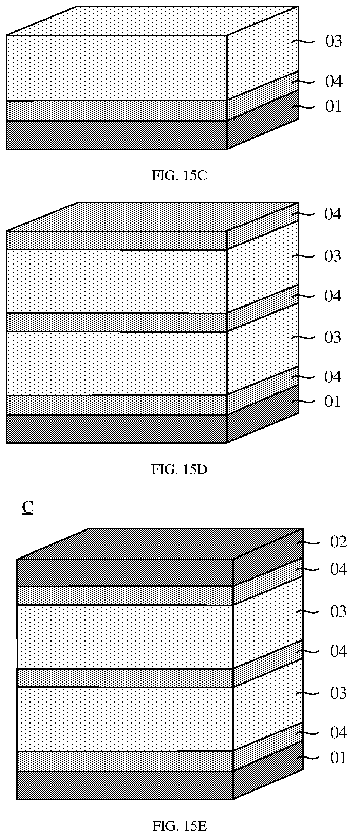

As shown in FIG. 15C, forming the ferroelectric layer 03 includes the following steps.

First, a structure in FIG. 15B is placed in the film-forming cavity, and a surface of the barrier layer 04 is blown by using ozone, to improve surface cleanliness of the barrier layer 04.

Then, when a material of the ferroelectric layer 03 includes hafnium zirconium oxide, an atomic layer deposition process may be used. Tetrakis dimethylamido hafnium (TDMA-Hf) is used as a precursor of hafnium. Tetrakis dimethylamido zirconium (TDMA-Zr) is used as a precursor of zirconium. Ozone is used as an oxygen source. The tetrakis dimethylamido hafnium, the tetrakis dimethylamido zirconium, and the ozone are cyclically pass through into the film-forming cavity, to form a hafnium zirconium oxide film on a surface of the barrier layer 04.

For example, a thickness of the ferroelectric layer 03 ranges from 3.8 nm to 4.2 nm. For example, the thickness of the ferroelectric layer 03 is 3.8 nm, 3.9 nm, 4.0 nm, 4.1 nm, or 4.2 nm.

In some examples, as shown in FIG. 15D, after the plurality of barrier layers 04 and the plurality of ferroelectric layers 03 are alternately formed by using the foregoing production method, an uppermost film layer is the barrier layer 04.

S30: As shown in FIG. 15E, form a second electrode 02 on the plurality of barrier layers 04 and the plurality of ferroelectric layers 03.

For example, a material of the second electrode 02 also includes titanium nitride. In this case, the second electrode 02 may also be prepared by using an atomic layer deposition process. A preparation method of the second electrode 02 is the same as the preparation method of the first electrode 01. Details are not described herein again.

According to the production method provided in the foregoing embodiment of this application, the barrier layer 04 is formed between the first electrode 01 and the ferroelectric layer 03, between the second electrode 02 and the ferroelectric layer 03, and between two adjacent ferroelectric layers 03. The barrier layer 04 may suppress diffusion of metal ions and oxygen ions, weaken oxidation effect of the electrodes and the oxygen ions, reduce a quantity of oxygen vacancies in the ferroelectric layer 03, prevent forming a conductive path by the metal ions and the oxygen vacancies, improve polarization fatigue and imprinting effect caused by the oxygen vacancy, and therefore improve a service life of the ferroelectric random access memory and accuracy of reading and writing data.

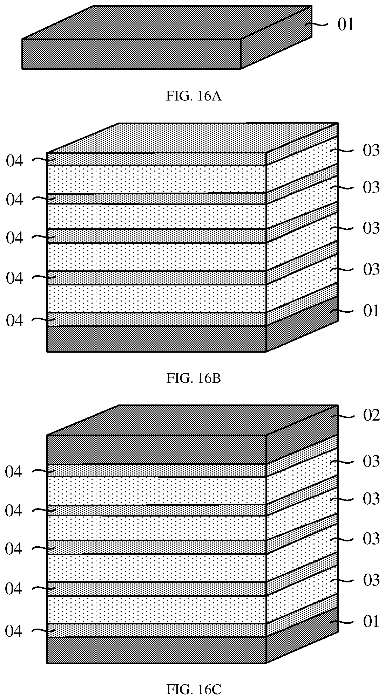

Some embodiments of this application further provide a preparation method of the ferroelectric capacitor C shown in FIG. 13A. FIG. 16A to FIG. 16C are diagrams of steps of preparing a ferroelectric capacitor according to some embodiments.

The preparation method is similar to the preparation method of the ferroelectric capacitor C shown in FIG. 11C, and similarities are not described again. The preparation method includes the following steps.

As shown in FIG. 16A, the first electrode 01 is formed.

As shown in FIG. 16B, a plurality of barrier layers 04 and a plurality of ferroelectric layers 03 are alternately formed on the first electrode 01.

Compared with that in the ferroelectric capacitor C shown in FIG. 11C, in FIG. 16B, there are more layers of the barrier layer 04 and the ferroelectric layer 03, and the ferroelectric layer 03 is thinner. For example, a thickness of the ferroelectric layer 03 ranges from 1.8 nm to 2.2 nm. For example, the thickness of the ferroelectric layer 03 is 1.8 nm, 1.9 nm, 2.0 nm, 2.1 nm, or 2.2 nm.

As shown in FIG. 16C, a second electrode 02 is formed on the plurality of barrier layers 04 and the plurality of ferroelectric layers 03.

According to the preparation method provided in the foregoing embodiment of this application, more barrier layers 04 are formed on the first electrode 01. This can improve suppression effect on metal ions and oxygen ions, weaken oxidation effect between the electrode and the oxygen ions, reduce a quantity of oxygen vacancies in the ferroelectric layer 03, and avoid forming a conductive path by metal ions and the oxygen vacancies.

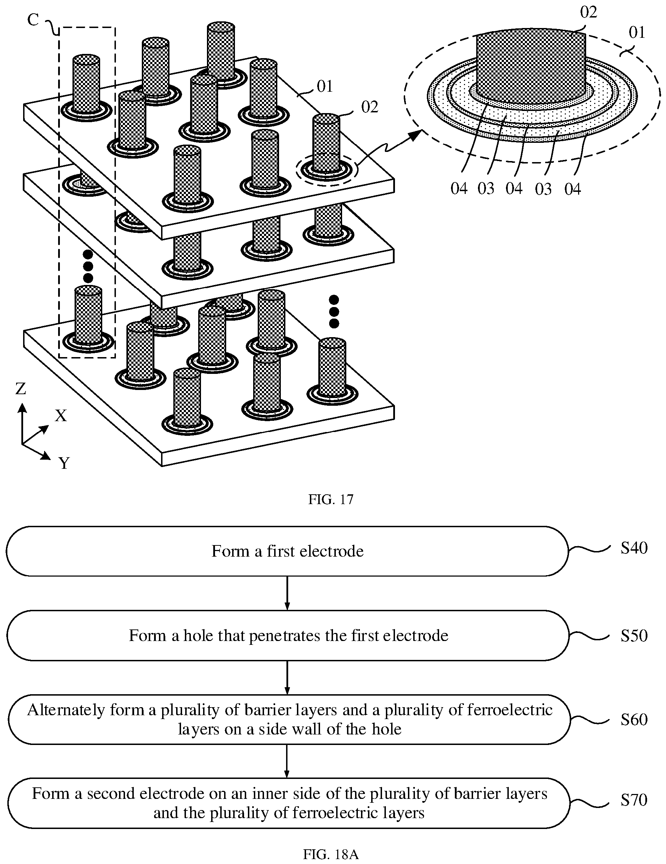

In addition, a structure of the ferroelectric capacitor C provided in some embodiments of this application may alternatively be a three-dimensional vertical structure. FIG. 17 is a diagram of a three-dimensional vertical structure of a ferroelectric capacitor according to some embodiment.

Refer to FIG. 17. A first electrode 01 of a ferroelectric capacitor C is a planar electrode, a second electrode 02 is a columnar electrode, and the second electrode 02 penetrates through the first electrode 01. A plurality of barrier layers 04 and a plurality of ferroelectric layers 03 are disposed around the second electrode 02, and the barrier layer 04 and the ferroelectric layer 03 alternately surround the second electrode 02, to separate the first electrode 01 from the second electrode 02.

The ferroelectric capacitor C uses the foregoing three-dimensional vertical structure design, so that an area occupied by the ferroelectric capacitor C in an X-Y plane can be reduced, and a quantity of ferroelectric capacitors C disposed per unit area in the X-Y plane can be increased, to increase a quantity of storage units 200 disposed per unit area. This helps improve a storage density of the ferroelectric random access memory.

For example, the storage unit 200 includes a transistor T and a ferroelectric capacitor C, the first electrode 01 is the planar electrode, and the second electrode 02 is the columnar electrode. In this case, the second electrode 02 is electrically connected to the transistor T, that is, the columnar electrode of the ferroelectric capacitor C is electrically connected to the transistor T.

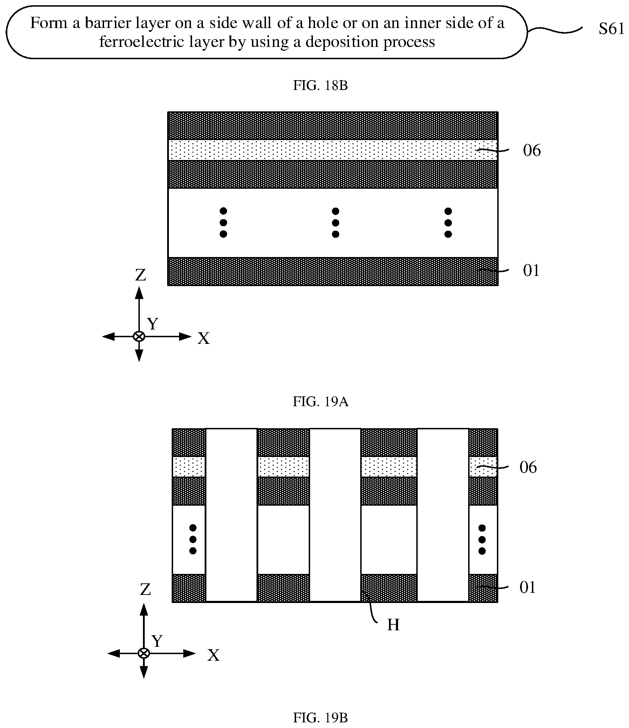

Some embodiments of this application provide the preparation method of the ferroelectric capacitor C shown in FIG. 17. FIG. 18A and FIG. 18B are flowcharts of preparing a ferroelectric capacitor according to some embodiments. FIG. 19A to FIG. 19D are diagrams of steps of preparing a ferroelectric capacitor according to some embodiments.

Refer to FIG. 18A. A preparation method of a ferroelectric capacitor C includes the following S40 to S70.

S40: As shown in FIG. 19A, form a first electrode 01.

For example, as shown in FIG. 19A, the first electrode 01 and an insulation layer 06 may be alternately formed, to form a three-dimensional stacked structure. The insulation layer 06 may separate two adjacent first electrodes 01.

In addition, a material of the first electrode 01 may include titanium nitride, and the first electrode 01 may be prepared by using an atomic layer deposition process.

S50: As shown in FIG. 19B, form a hole H that penetrates the first electrode 01.

For example, the first electrode 01 and the insulation layer 06 may be etched by using an etching process, to form the hole H that penetrates the first electrode 01 and the insulation layer 06.

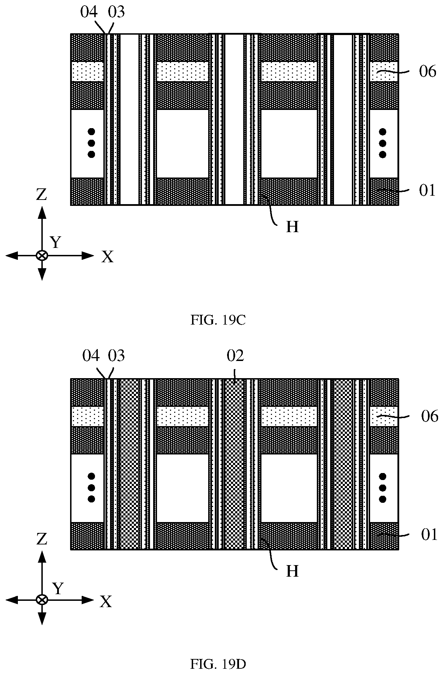

S60: As shown in FIG. 19C, alternately form a plurality of barrier layers 04 and a plurality of ferroelectric layers 03 on a side wall of the hole H.

Refer to FIG. 18B. The forming the barrier layer 04 includes the following S61.

S61: Form the barrier layer 04 on the side wall of the hole H by using a deposition process.

For example, a material of the barrier layer 04 includes single-layer graphene. In this case, the barrier layer 04 is directly formed on the side wall of the hole H by using a chemical vapor deposition process, so that a preparation process can be simplified and preparation costs can be reduced.

As shown in FIG. 19C, the forming the ferroelectric layer 03 includes the following steps.

First, an inner surface of the barrier layer 04 is blown by using ozone, to improve cleanliness of the inner surface of the barrier layer 04.

Then, when the material of the ferroelectric layer 03 includes hafnium zirconium oxide, a hafnium zirconium oxide film may be formed on the surface of the barrier layer 04 by using an atomic layer deposition process.

In some examples, as shown in FIG. 19C, after the plurality of barrier layers 04 and the plurality of ferroelectric layers 03 are alternately formed on the side wall of the hole H by using the foregoing production method, an innermost film layer is the barrier layer 04.

S70: As shown in FIG. 19D, form a second electrode 02 on an inner side of the plurality of barrier layers 04 and the plurality of ferroelectric layers 03.

For example, a material of the second electrode 02 includes titanium nitride, and the second electrode 02 may be prepared by using an atomic layer deposition process.

According to the production method provided in the foregoing embodiment of this application, the barrier layer 04 is formed between the first electrode 01 and the ferroelectric layer 03, between the second electrode 02 and the ferroelectric layer 03, and between two adjacent ferroelectric layers 03. The barrier layer 04 may suppress diffusion of metal ions and oxygen ions, weaken oxidation effect of the electrodes and the oxygen ions, and reduce a quantity of oxygen vacancies in the ferroelectric layer 03, and may also prevent the metal ions and the oxygen vacancies to form a conductive path. Polarization fatigue and imprinting effect caused by the oxygen vacancy are improved, thereby improving a service life of the ferroelectric random access memory and accuracy of reading and writing data.

The ferroelectric random access memory and the electronic device 1 provided in some embodiments of this application include the ferroelectric capacitor C provided in any one of the foregoing embodiments. For beneficial effect that can be achieved by the ferroelectric random access memory and the electronic device 1, refer to the foregoing beneficial effect of the ferroelectric capacitor C. Details are not described herein again.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A ferroelectric random access memory, wherein the ferroelectric random access memory comprises a ferroelectric capacitor; and
the ferroelectric capacitor comprises:
a first electrode and a second electrode that are disposed opposite to each other; and
a plurality of barrier layers and a plurality of ferroelectric layers, disposed between the first electrode and the second electrode, wherein the barrier layers and the ferroelectric layers are alternately stacked; and
at least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

2. The ferroelectric random access memory according to claim 1, wherein a material of the barrier layer comprises graphene.

3. The ferroelectric random access memory according to claim 1 or 2, wherein the material of the barrier layer comprises single-layer graphene.

4. The ferroelectric random access memory according to any one of claims 1 to 3, wherein the ferroelectric capacitor comprises at least three ferroelectric layers; and
in a direction from the first electrode to the second electrode, thicknesses of the at least three ferroelectric layers first increase and then decrease.

5. The ferroelectric random access memory according to any one of claims 1 to 4, wherein a thickness of the barrier layer ranges from 0.334 nm to 0.4 nm.

6. The ferroelectric random access memory according to any one of claims 1 to 5, wherein a material of at least one of the first electrode and the second electrode comprises titanium nitride.

7. The ferroelectric random access memory according to any one of claims 1 to 6, wherein the first electrode and the second electrode are planar electrodes, and the first electrode and the second electrode are stacked.

8. The ferroelectric random access memory according to any one of claims 1 to 6, wherein the first electrode is a planar electrode, and the second electrode is a columnar electrode; and
the second electrode penetrates the first electrode, and the plurality of barrier layers and the plurality of ferroelectric layers are disposed around the second electrode.

9. The ferroelectric random access memory according to any one of claims 1 to 8, wherein the ferroelectric random access memory comprises a plurality of storage units arranged in an array, and the storage unit comprises the ferroelectric capacitor and a transistor; and
the first electrode and the second electrode are the planar electrodes, and one of the first electrode and the second electrode is electrically connected to the transistor; or the first electrode is the planar electrode, the second electrode is the columnar electrode, and the second electrode is electrically connected to the transistor.

10. A preparation method of a ferroelectric random access memory, comprising:
forming a first electrode;
alternately forming a plurality of barrier layers and a plurality of ferroelectric layers on the first electrode; and
forming a second electrode on the plurality of barrier layers and the plurality of ferroelectric layers, wherein
at least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

11. The preparation method according to claim 10, wherein forming the barrier layer comprises:
forming the barrier layer on a substrate by using a deposition process; and
transferring the barrier layer to the first electrode or the ferroelectric layer.

12. A preparation method of a ferroelectric random access memory, comprising:
forming a first electrode;
forming a hole that penetrates the first electrode;
alternately forming a plurality of barrier layers and a plurality of ferroelectric layers on a side wall of the hole; and
forming a second electrode on an inner side of the plurality of barrier layers and the plurality of ferroelectric layers, wherein
at least one barrier layer is located between the first electrode and a ferroelectric layer that is in the plurality of ferroelectric layers and that is closest to the first electrode; and/or at least one barrier layer is located between the second electrode and a ferroelectric layer that is in the plurality of ferroelectric layers and that is closest to the second electrode.

13. The preparation method according to claim 12, wherein forming the barrier layer comprises:
forming the barrier layer on the side wall of the hole or on the inner side of the ferroelectric layer by using a deposition process.

14. An electronic device, comprising:
a circuit board; and
the ferroelectric random access memory according to any one of claims 1 to 9, wherein the ferroelectric random access memory is disposed on the circuit board, and is electrically connected to the circuit board.
